(19) Europäisches Patentamt
European Patent Office
Office européen des brevets

(11) EP 4 790 728 A1

(12) # EUROPEAN PATENT APPLICATION

published in accordance with Art. 153(4) EPC

(43) Date of publication:
**12.08.2026 Bulletin 2026/33**

(21) Application number: **24874505.1**

(22) Date of filing: **24.09.2024**

(51) International Patent Classification (IPC):
***H01B 12/00** (2006.01)* ***C01B 35/04** (2006.01)*
***G01F 23/22** (2006.01)*

(52) Cooperative Patent Classification (CPC):
**C01B 35/04; G01F 23/22; H01B 12/00**

(86) International application number:
**PCT/JP2024/033854**

(87) International publication number:
**WO 2025/074897 (10.04.2025 Gazette 2025/15)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **04.10.2023 JP 2023172580**
**18.09.2024 JP 2024160554**

(71) Applicant: **Yamamoto Electric Works Co., Ltd.**
**Kobe-shi, Hyogo 653-0031 (JP)**

(72) Inventors:
- **TAKADA Yoshihiro**
**Kobe-city, Hyogo 653-0031 (JP)**
- **FUKUMOTO Shoichi**
**Kobe-city, Hyogo 653-0031 (JP)**

(74) Representative: **TBK**
**Bavariaring 4-6**
**80336 München (DE)**

(54) **SUPERCONDUCTOR, METHOD FOR PRODUCING SUPERCONDUCTOR, LIQUID LEVEL SENSOR FOR LIQUID HYDROGEN, AND LIQUID LEVEL GAUGE FOR LIQUID HYDROGEN**

(57) [Problem] The present invention addresses the problem in realizing a superconducting material which can be used for a liquid level gauge for liquid hydrogen, enabling a simple production method, and achieving reproducibility.

[Solution] The present invention provides a superconductor which is composed of a metal compound that has a molar ratio of magnesium (Mg) to boron (B) of 1:2, and does not contain SiC. This superconductor is characterized in that the critical temperature (Tc) thereof, at which the electric resistance is substantially zero, is about 32K to about 34K. As a result, it is possible to realize a liquid level gauge for liquid hydrogen, which enables a simple production method and achieving reproducibility.

FIG. 1

OUTPUT VOLTAGE (mV)
1.3
1.2
1.1
1.0
0.9
0.8
0.7
0.6
0.5
0.4
0.3
0.2
0.1
0
20 21 22 23 24 25 26 27 28 29 30 31 32 33 34 35 36 37 38 39 40 41 42 43 44 45 46 47 48 49 50
TEMPERATURE (K)
(a)
(b)
(c)
(d)
(e)
(f)
(g)
(a) 0.7μm Tc=35.6K
(b) 1μm Tc=35.5K
(c) 2μm Tc=34.3K
(d) 14μm Tc=32.4K
(e) 36μm Tc=27.3K
(f) 38μm Tc=29.2K
(g) 39μm Tc=26.9K

EP 4 790 728 A1

## Description

### Technical Field

The present invention relates to a superconductor, a method of manufacturing a superconductor, a liquid level sensor for liquid hydrogen, and a liquid level gauge for liquid hydrogen.

### Background Art

Global warming is increasingly recognized worldwide as a common challenge that we must address now and in the future. A major challenge is the movement toward decarbonization to reduce fossil fuel consumption. One option therefor is utilization and active use of hydrogen. In our country, the "Basic Policy for Realizing GX (Green Transformation)" was decided by the Cabinet in February 2023, advocating for the promotion of hydrogen introduction. In this context, accurate measurement of liquid hydrogen quantities is required in the transportation, storage, and consumption of liquid hydrogen.

Liquid hydrogen is a cryogenic substance having a boiling point of about 20 K under an ordinary pressure. As a sensor material for liquid hydrogen level gauges utilizing changes in electrical resistance, materials exhibiting superconductivity at temperatures higher than that of liquid hydrogen have been sought. At the beginning of the 21st century, the relatively high-temperature superconductivity of $MgB_2$ (magnesium diboride) as an intermetallic compound was reported, and efforts to develop liquid hydrogen level gauges using $MgB_2$ are progressing.

Patent Literature 1 describes a matter of an intermetallic compound composed of magnesium (Mg) and boron (B) having a critical temperature (Tc) at which an electrical resistance becomes substantially zero of 39 K.

Patent Literature 2 describes a matter in which a liquid level gauge for liquid hydrogen was configured using an elongated superconductor in which part of the B atoms in $MgB_2$ were replaced with C atoms.

Patent Literature 3 describes a matter in which a superconducting wire is manufactured by filling a metal sheath from one end with a first powder obtained by mixing Mg and B having an average particle diameter of less than 2 μm, filling metal sheath from the other end with a second powder obtained by mixing Mg and B having an average particle diameter of 2 μm or more and less than 15 μm, and then performing wire drawing processing and heat processing.

### Citation List

#### Patent Literature

Patent Literature 1: JP 2002-211916 A
Patent Literature 2: JP 2000-175034 A
Patent Literature 3: WO 2014/162379 A

### Summary of Invention

#### Technical Problem

However, the intermetallic compound described in Patent Literature 1 had a high critical temperature (Tc) of 39 K, and thus had a problem that the critical temperature (Tc) is too high for a superconductor used in a level gauge for liquid hydrogen, which has a boiling point of about 20 K under an ordinary pressure.

Furthermore, the superconductor described in Patent Literature 2, in which part of the B atoms in $MgB_2$ was replaced with C atoms, had problems that the manufacturing method was complicated, and it was difficult to obtain reproducibility, because part of the B atoms must be replaced with C atoms.

Furthermore, the superconducting wire described in Patent Literature 3 also had a problem that the manufacturing method was complicated because it used two types of B having different average particle diameters.

An object of the present invention is to solve the above-mentioned problem to realize a superconducting material which can be used for a liquid hydrogen level gauge, whose manufacturing method is simple, and which provides reproducibility.

#### Solution to Problem

In order to solve the above-mentioned problem, the present invention provides a superconductor including a

metal compound of magnesium (Mg) and boron (B) at a molar ratio of 1:2 and containing no SiC, wherein the superconductor has a critical temperature (Tc) at which an electrical resistance becomes substantially zero of from about 32 K to about 34 K.

This configuration can realize a superconductor which can be used for a liquid hydrogen level gauge, whose manufacturing method is simple, and which provides reproducibility. Here, the temperature of liquid hydrogen is 20 K at an ordinary pressure, but increases to 30 K at 1 MPaG. Therefore, in order to cope with the temperature of liquid hydrogen of from 20 to 30 K, a superconductor for a liquid hydrogen level gauge needs to be a superconductor having at least a critical temperature (Tc) = 31 K or more. Furthermore, as described later, the Applicant found that a superconductor having Tc = from about 32 K to about 34 K can be realized by producing $MgB_2$ by mixing boron (B) having an average particle diameter of from 17 μm to 7 μm at a molar ratio of 2 to 1 of magnesium (Mg).

Moreover, in order to solve the above-mentioned problem, the present invention provides a method of manufacturing a superconductor having a critical temperature (Tc) at which an electrical resistance becomes substantially zero of from about 32 K to about 34 K, the method including: a mixing step of mixing boron (B) having an average particle diameter of from 17 μm to 7 μm at a molar ratio of 2 to 1 of magnesium (Mg); and a baking step of baking a mixture of Mg and B mixed in the mixing step.

This configuration can realize a superconducting material which can be used for a liquid hydrogen level gauge, whose manufacturing method is simple, and which provides reproducibility.

Furthermore, in order to solve the above-mentioned problem, the present invention provides a liquid level sensor for liquid hydrogen, including: an elongated superconductor being a metal compound including $MgB_2$ containing no SiC and having a critical temperature (Tc) at which an electrical resistance becomes substantially zero of from about 32 K to about 34 K; and a coating metal covering a surface of the superconductor.

This configuration can realize a liquid level sensor for liquid hydrogen including a superconducting material which can be used for a liquid hydrogen level gauge, whose manufacturing method is simple, and which provides reproducibility.

Furthermore, in order to solve the above-mentioned problem, the present invention provides a liquid level gauge for liquid hydrogen, including: a liquid level sensor for liquid hydrogen, including: an elongated superconductor being a metal compound including $MgB_2$ containing no SiC and having a critical temperature (Tc) at which an electrical resistance becomes substantially zero of from about 32 K to about 34 K; and a coating metal covering a surface of the superconductor; a heater for heating the liquid level sensor for liquid hydrogen; a power source for passing a current through the liquid level sensor for liquid hydrogen; and a voltmeter for measuring a voltage in the liquid level sensor for liquid hydrogen.

This configuration can realize a liquid level gauge for liquid hydrogen whose manufacturing method is simple, and which provides reproducibility.

## Advantageous Effects of Invention

According to the superconductor and the method for manufacturing the superconductor of the present invention, a superconductor whose manufacturing method is simple and which provides reproducibility can be realized. Therefore, a liquid level sensor for liquid hydrogen and a liquid hydrogen level gauge can be easily realized.

## Brief Description of Drawings

Fig. 1 illustrates measurement data of the critical temperature (Tc) of the superconductor in Example 1 of the present invention (including comparative data).
Fig. 2 is a diagram illustrating the liquid level sensor for liquid hydrogen in Example 1 of the present invention.
Fig. 3 is a diagram illustrating the liquid level gauge for liquid hydrogen in Example 1 of the present invention.
Fig. 4 is a graph showing the relationship between the average particle diameter of boron and the critical temperature in Example 1 of the present invention.

## Description of Embodiments

### Example 1

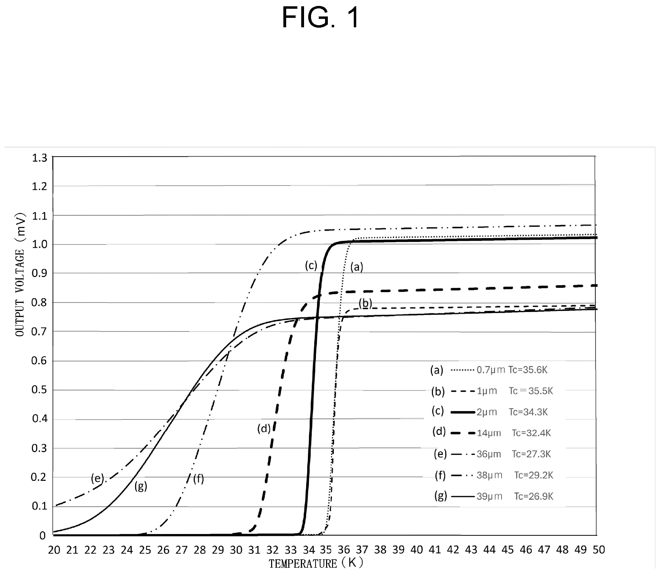

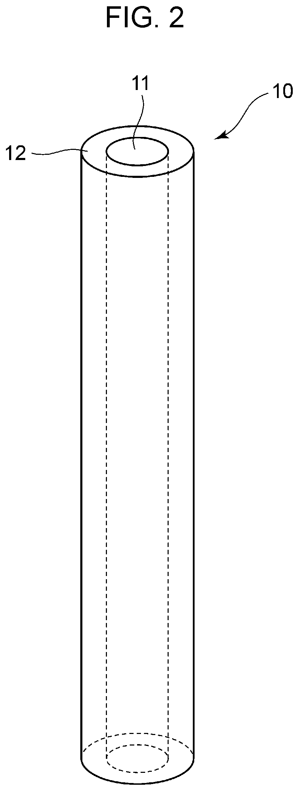

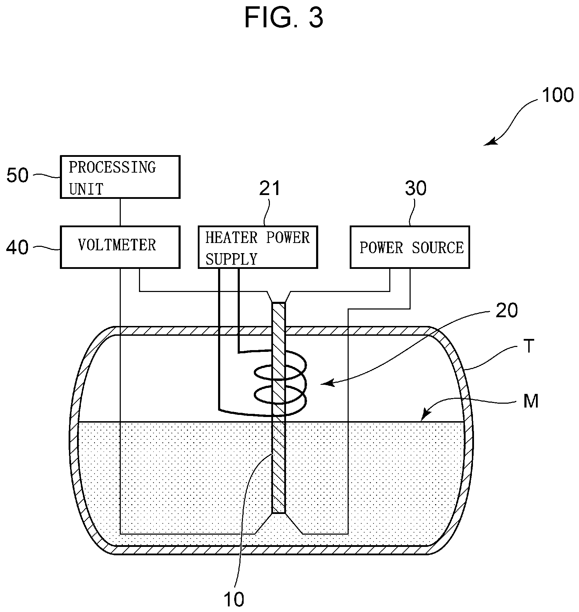

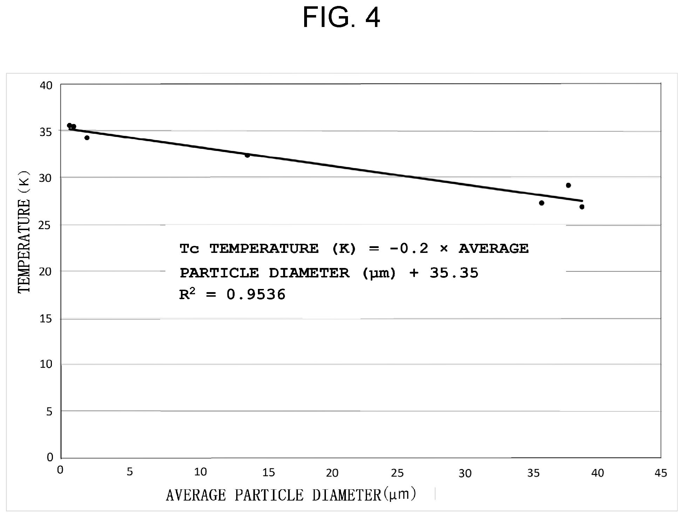

Example 1 of the present invention will be described with reference to Figs. 1 to 4. Fig. 1 illustrates measurement data of the critical temperature (Tc) of the superconductor in Example 1 of the present invention (including Comparative Example). Fig. 2 is a diagram illustrating the liquid level sensor for liquid hydrogen in Example 1 of the present invention. Fig. 3 is a diagram illustrating the liquid level gauge for liquid hydrogen in Example 1 of the present invention. Fig. 4 is a graph showing the relationship between the average particle diameter of boron and the critical temperature in Example 1 of

the present invention.

(Superconductor)

The superconductor in Example 1 can be used for a liquid level gauge for liquid hydrogen. The critical temperature (Tc) at which an electrical resistance becomes substantially zero of liquid hydrogen is 20 K at an ordinary pressure, but the critical temperature (Tc) increases to 30 K at 1 MPaG. Therefore, a superconductor having Tc = from 32.4 K to 34.3 K was realized as a superconductor for a liquid hydrogen level gauge in order to cope with a critical temperature Tc = from 20 K to 30 K.

The superconductor in Example 1 is composed of magnesium (Mg) and boron (B) without using SiC, and is manufactured as an intermetallic compound by filling a hollow metal tube with a mixture obtained by mixing boron (B) at a molar ratio of 2 to 1 of magnesium (Mg), subjecting the mixture to a wire drawing treatment, and then thermally treating the mixture in an argon atmosphere at about 600°C. As shown in the experimental data in Fig. 1, the critical temperature (Tc) of the superconductor is 32.4 K for (d) and 34.3 K for (c). In Fig. 1, the horizontal axis indicates a temperature (K) and the vertical axis indicates an output voltage (mV), and when an output voltage becomes substantially zero, a resistance becomes zero, and the temperature at that time is a critical temperature (Tc). In Fig. 1, the graph of (d) shows a result of measuring a critical temperature (Tc) = 32.4 K when boron having an average particle diameter of 14 μm was mixed with magnesium, and the graph of (c) shows a result of measuring a critical temperature (Tc) = 34.3 K when boron having an average particle diameter of 2 μm was mixed with magnesium. The magnesium used at this time was magnesium with 325 mesh (manufactured by alfa Aesar, particle diameter: about 44 μm).

The experimental result comparing measurements of critical temperature (Tc) while varying the average particle diameter of boron will be described with reference to Fig. 1. All of the graphs (a), (b), (e), (f) and (g) in Fig. 1 are experimental data (comparative data) where the critical temperature (Tc) did not fall within a range of from 32 K to 34 K. That is, the graph of (a) is a result of mixing boron having an average particle diameter of 0.7 μm at a ratio of 2 to 1 of magnesium, showing a critical temperature (Tc) = 35.6 K. The graph (b) is a result of mixing boron having an average particle diameter of 1 μm at a ratio of 2 to 1 of magnesium, showing a critical temperature (Tc) = 35.5 K. That is, the data in (a) and (b) show critical temperatures (Tc) higher than 35 K, and thus cannot be used as a superconductor for a liquid hydrogen level gauge.

The graph of (e) in Fig. 1 is a result of mixing boron having an average particle diameter of 36 μm at a ratio of 2 to 1 of magnesium, showing a critical temperature (Tc) = 27.3 K. Furthermore, the graph of (f) is a result of mixing boron having an average particle diameter of 38 μm at a ratio of 2 to 1 of magnesium, showing a critical temperature (Tc) = 29.2 K. Furthermore, the graph of (g) is a result of mixing boron having an average particle diameter of 39 μm at a ratio of 2 to 1 of magnesium, showing a critical temperature (Tc) = 26.9 K. That is, the data in (e), (f) and (g) show critical temperatures (Tc) lower than 32 K, and thus cannot be used as a superconductor for a liquid hydrogen level gauge.

The graph of (d) in Fig. 1 is a result of mixing boron having an average particle diameter of 14 μm at a ratio of 2 to 1 of magnesium, showing a critical temperature (Tc) = 32.4 K. Furthermore, the graph of (c) is a result of mixing boron having an average particle diameter of 2 μm at a ratio of 2 to 1 of magnesium, showing a critical temperature (Tc) = 34.3 K. That is, the data of (c) and (d) indicate values close to the target as a superconductor for a liquid hydrogen level gauge.

Here, how to obtain an average particle diameter and a critical temperature (Tc) shown in the experimental data will be described. The average particle diameter was determined by a measurement with SALD-2300 (a laser diffraction particle diameter distribution measurement device) of Shimadzu Corporation. The critical temperature (Tc) is not measured by JISH7309, but obtained by approximating measurement data (data of from 25 K to 45 K) of a short sample obtained by a cryostat device by a sigmoid curve (transition curve) using the least squares method, and defining a value having a height of 50% as Tc.

From the above-mentioned experimental data, it was found that the critical temperature (Tc) is high when the average particle diameter of boron is small, and the critical temperature (Tc) is low when the average particle diameter is large. Next, an investigation was conducted to determine the required average particle diameter of boron to obtain critical temperature (Tc) of about 32 K to about 34 K. In the graph shown in Fig. 4, the horizontal axis represents average particle diameter of boron (μm) and the vertical axis represents critical temperature (Tc). Seven data points from the experimental results were plotted on this graph. As shown in Fig. 4, these data points exhibit a very strong approximate linear relationship as shown in Equation 1.

$$\text{Tc temperature} = -0.2 \times \text{average particle diameter } (\mu\text{m}) + 35.35 \qquad \text{Equation 1:}$$

The average particle diameter of boron for obtaining critical temperature (Tc) = about 32 K to about 34 K obtained from this approximate straight line is from 7 to 17 μm. That is, if boron having an average particle diameter of from 7 to 17 μm is mixed with magnesium in a ratio of 2:1, a superconductor with critical temperature (Tc) of from 32 K to 34 K can be obtained.

Incidentally, in Example 1, the particle diameter of boron is expressed as an average particle diameter. The average particle diameter is a representative diameter obtained through the averaging process of the values measured by the above-mentioned SALD-2300, calculated by summing products of a particle diameter (the horizontal axis of the histogram) and a frequency (the vertical axis of the histogram). However, a difference in particle diameter distribution may result in a different critical temperature (Tc). Therefore, in the present application, a critical temperature (Tc) obtained from an approximate line is expressed as "about 32 K to about 34 K" with "about" prefixed.

(Method of Manufacturing Superconductor)

First, a mixing step is performed, in which boron (B) having an average particle diameter of 14 μm was mixed at a molar ratio of 2 to 1 of magnesium (Mg) of 325 mesh (manufactured by alfa Aesar, particle diameter: about 44 μm). Next, a baking step is performed, in which the mixture of Mg and B from the mixing step is baked in an argon atmosphere at 600°C for 1 hour to complete a superconductor of $MgB_2$. As described later, when producing an elongated liquid level sensor for liquid hydrogen, the baked $MgB_2$ may be powdered, placed in a long tube, and subjected to a wire drawing treatment, or a mixed powder of Mg and B may be subjected to a wire drawing treatment and then a baking treatment.

Here, boron (B) sold by Nilaco with a particle diameter of 40 μm was purchased and used. However, when the average particle diameter was measured with the above-mentioned laser diffraction particle diameter distribution measuring device, the average particle diameter was 14 μm. Furthermore, as magnesium (Mg), magnesium sold by alfa Aesar as 325 mesh (particle diameter: about 44 μm) was purchased and used.

Boron (B) having an average particle diameter of 14 μm was mixed at a molar ratio of 2 to 1 of magnesium (Mg) of 325 mesh (manufactured by alfa Aesar, particle diameter: about 44 μm), subjected to a wire drawing treatment, and the mixture was baked to give a superconductor. The superconductor had a critical temperature (Tc) of 32.4 K (see Fig. 1).

Furthermore, a mixing step was performed, in which boron (B) with an average particle diameter of 2 μm is mixed at a molar ratio of 2 to 1 of magnesium (Mg) of 325 mesh (manufactured by alfa Aesar, particle diameter: about 44 μm). Next, a baking step is performed, in which the mixture of Mg and B mixed in the mixing step is baked at 600°C for 1 hour in an argon atmosphere.

Here, as boron (B), boron sold by nanogaraphi technology having a particle diameter of 10 μm was purchased and used, and when the average particle diameter was measured by the above-mentioned laser diffraction particle diameter distribution measurement device, the average particle diameter was 2 μm. Furthermore, as magnesium (Mg), magnesium sold by alfa Aesar as 325 mesh (particle diameter: about 44 μm) was purchased and used.

Boron (B) having an average particle diameter of 2 μm was mixed at a molar ratio of 2 to 1 of magnesium (Mg) of 325 mesh (manufactured by alfa Aesar, particle diameter: about 44 μm), and the mixture was baked to give a superconductor. The superconductor had a critical temperature (Tc) of 34.3 K (see Fig. 1).

In Example 1, the superconductor was manufactured without containing substances other than $MgB_2$, but it is not limited to this and may be modified appropriately. For example, it may contain SiC or other substances that do not affect critical temperature (Tc).

After mixing boron (B) and magnesium (Mg) and before the baking step, powder particles of Mg and B are in contact at contact points. When the baking step is performed in this state, $MgB_2$ crystal nuclei are generated from the contact points and grow. The number of $MgB_2$ crystal nuclei is influenced by the number of contact points, and the number of contact points varies depending on the particle diameter ratio of the mixed powders. When there are many crystal nuclei (many contact points), the overall reaction is faster, and adjacent crystals collide at the interface and fuse as they grow, resulting in a perfect crystal without unreacted powder as impurities.

Therefore, in the particle diameter range of several μm to several tens of μm, a smaller particle diameter of B relative to Mg increases the number of contact points, resulting in $MgB_2$ forming a more perfect crystal and thus a higher critical temperature (Tc). This supports the relationship between the average particle diameter of B and the critical temperature (Tc) explained in the above-mentioned Fig. 4.

Through the above, it has become possible to manufacture a superconductor with reproducibility. However, in order to ensure further reproducibility, it is necessary to maintain identical conditions by strictly controlling the heat treatment (heating, constant temperature, and rate and time for temperature decrease), the particle diameters and the particle diameter ratio of Mg and B, the particle diameter distribution, etc.

(Liquid Level Sensor for Liquid Hydrogen)

Liquid level sensor 10 for liquid hydrogen in Example 1 includes superconductor 11 and coating metal 12, forming an elongated core wire with a length of about 1 m and a diameter of about 0.3 mm, as shown in Fig. 2. Superconductor 11 was formed by mixing boron (B) having an average particle diameter of 14 μm at a molar ratio of 2 to 1 of magnesium (Mg) of 325 mesh (manufactured by alfa Aesar, particle diameter: about 44 μm) (mixing step), subjecting the mixture to a wire drawing treatment in a wire drawing step, and then performing a baking step to give a superconductor of $MgB_2$. In the wire

drawing step, the mixture of Mg and B obtained from the mixing step was formed into a powder, and the powder was placed in a tube of about 1 m and subjected to a wire drawing treatment to prepare an elongated shape.

Incidentally, the mixing step, the wire drawing step, and the baking step were performed in this order in Example 1; however, the order is not limited to this and may be appropriately changed. For example, the baking step may be performed after the mixing step, followed by a powdering step for forming a powder and then the wire drawing step may be performed. Furthermore, the heat treatment step may be performed multiple times.

While an elongated core wire with a length of about 1 m and a diameter of about 0.3 mm was formed in Example 1, these are not limited and can be appropriately changed. For example, the length may be 5 m or 0.5 m, depending on the depth of liquid hydrogen.

Furthermore, the diameter was set to about 0.3 mm in Example 1; however, the diameter is not necessarily limited thereto, and can be appropriately changed. For example, the diameter may also be 0.5 mm or 0.2 mm, and the diameter may be selected in consideration of the critical temperature (Tc).

Furthermore, the coating metal 12 may be any metal with high conductivity. While cupronickel was used in Example 1, other metals such as stainless steel may be used.

Furthermore, boron (B) having an average particle diameter of 14 μm was mixed at a molar ratio of 2 to 1 of magnesium (Mg) of 325 mesh (manufactured by alfa Aesar, particle diameter: about 44 μm) in Example 1. However, the average particle diameter is not necessarily limited thereto, and can be appropriately changed. For example, boron (B) having an average particle diameter of 2 μm may be mixed at a molar ratio of 2 to 1 of magnesium (Mg) of 325 mesh (manufactured by alfa Aesar, particle diameter: about 44 μm).

The resistance value of liquid level sensor 10 for liquid hydrogen at an ordinary temperature in Example 1 is 1 Ω/m to 6 Ω/m, but the resistance value is not limited thereto and can be appropriately changed.

Furthermore, the length of liquid level sensor 10 for liquid hydrogen was set to about 1 m in Example 1. However, the length is not necessarily limited thereto, and can be appropriately changed. For example, the length may be about 5 m or about 0.5 m. The length may be a length at which at least the liquid surface of liquid hydrogen can be measured.

(Liquid Level Gauge for Liquid Hydrogen)

The configuration of liquid level gauge 100 for liquid hydrogen in Example 1 is shown in Fig. 3. Tank T is filled with liquid hydrogen M, and liquid level sensor 10 for liquid hydrogen is installed in a vertical direction in tank T. Liquid level sensor 10 for liquid hydrogen is disposed deep in the liquid of liquid hydrogen M.

Liquid level sensor 10 for liquid hydrogen in an ordinary temperature area above the liquid level can heat liquid level sensor 10 for liquid hydrogen by generating resistance heat by causing a current to flow from heater power supply 21 to heater 20. As a result, the influence of the temperature of liquid hydrogen M is eliminated, and the area above the liquid level can be maintained in a normal conducting state.

Power source 30 is connected and voltmeter 40 is connected to the both ends of liquid level sensor 10 for liquid hydrogen. A current is passed from power source 10 through liquid level sensor 10 for liquid hydrogen, and a voltage across the both ends of liquid level sensor 10 for liquid hydrogen is measured by voltmeter 40 and stored in processing unit 50. A liquid level position is then calculated from the stored voltage based on a predetermined known relationship equation.

As mentioned above, in Example 1, a superconductor which can be used for a liquid hydrogen level gauge, whose manufacture method is simple and which can provide reproducibility can be obtained by a superconductor including a metal compound of magnesium (Mg) and boron (B) at a molar ratio of 1:2 and containing no SiC,
wherein the superconductor has a critical temperature (Tc) at which an electrical resistance becomes substantially zero of from about 32 K to about 34 K.

Furthermore, in Example 1, a superconductor for a liquid level gauge for liquid hydrogen whose manufacture method is simple and which can provide reproducibility can be realized by a method of manufacturing a superconductor having a critical temperature (Tc) at which an electrical resistance becomes substantially zero of from about 32 K to about 34 K, the method including:

a mixing step of mixing boron (B) having an average particle diameter of from 17 μm to 7 μm at a molar ratio of 2 to 1 of magnesium (Mg); and
a baking step of baking a mixture of Mg and B mixed in the mixing step.

Furthermore, in Example 1, a liquid level gauge for liquid hydrogen whose manufacture method is simple and which can provide reproducibility can be realized by a liquid level sensor for liquid hydrogen, including: an elongated superconductor being a metal compound including $MgB_2$ containing no SiC and having a critical temperature (Tc) at which an electrical resistance becomes substantially zero of from about 32 K to about 34 K; and a coating metal covering a surface of the superconductor.

Moreover, in Example 1, a liquid level gauge for liquid hydrogen whose manufacture method is simple and which

can provide reproducibility can be realized by a liquid level gauge for liquid hydrogen, including:

a liquid level sensor for liquid hydrogen, including: an elongated superconductor being a metal compound including $MgB_2$ containing no SiC and having a critical temperature (Tc) at which an electrical resistance becomes substantially zero of from about 32 K to about 34 K; and a coating metal covering a surface of the superconductor;
a heater for heating the liquid level sensor for liquid hydrogen;
a power source for passing a current through the liquid level sensor for liquid hydrogen; and
a voltmeter for measuring a voltage in the liquid level sensor for liquid hydrogen.

Industrial Applicability

The superconductor, the method for manufacturing the superconductor, the liquid level sensor for liquid hydrogen, and the liquid level gauge for liquid hydrogen in the present invention can be widely applied to the field of liquid level gauges for liquid hydrogen.

Reference Signs List

10: liquid level sensor for liquid hydrogen
11: superconductor
12: coating metal
20: heater unit
21: heater power supply
30: power source
40: voltmeter
50: processing unit
100: liquid level gauge for liquid hydrogen

## Claims

**1.** A superconductor comprising a metal compound of magnesium (Mg) and boron (B) at a molar ratio of 1:2 and containing no SiC,
wherein the superconductor has a critical temperature (Tc) at which an electrical resistance becomes substantially zero of from about 32 K to about 34 K.

**2.** A method of manufacturing a superconductor having a critical temperature (Tc) at which an electrical resistance becomes substantially zero of from about 32 K to about 34 K, the method comprising:

a mixing step of mixing boron (B) having an average particle diameter of from 17 μm to 7 μm at a molar ratio of 2 to 1 of magnesium (Mg); and
a baking step of baking a mixture of Mg and B mixed in the mixing step.

**3.** A liquid level sensor for liquid hydrogen, comprising:

an elongated superconductor being a metal compound comprising $MgB_2$ containing no SiC and having a critical temperature (Tc) at which an electrical resistance becomes substantially zero of from about 32 K to about 34 K; and
a coating metal covering a surface of the superconductor.

**4.** A liquid level gauge for liquid hydrogen, comprising:

a liquid level sensor for liquid hydrogen, comprising: an elongated superconductor being a metal compound comprising $MgB_2$ containing no SiC and having a critical temperature (Tc) at which an electrical resistance becomes substantially zero of from about 32 K to about 34 K; and a coating metal covering a surface of the superconductor;
a heater for heating the liquid level sensor for liquid hydrogen;
a power source for passing a current through the liquid level sensor for liquid hydrogen; and

a voltmeter for measuring a voltage in the liquid level sensor for liquid hydrogen.

# FIG. 1

OUTPUT VOLTAGE (mV)
1.3
1.2
1.1
1.0
0.9
0.8
0.7
0.6
0.5
0.4
0.3
0.2
0.1
0
20 21 22 23 24 25 26 27 28 29 30 31 32 33 34 35 36 37 38 39 40 41 42 43 44 45 46 47 48 49 50
TEMPERATURE (K)
(a)
(b)
(c)
(d)
(e)
(f)
(g)
(a) 0.7μm Tc=35.6K
(b) 1μm Tc=35.5K
(c) 2μm Tc=34.3K
(d) 14μm Tc=32.4K
(e) 36μm Tc=27.3K
(f) 38μm Tc=29.2K
(g) 39μm Tc=26.9K

FIG. 2

11
10
12

FIG. 3

100
50
PROCESSING UNIT
21
30
40
VOLTMETER
HEATER POWER SUPPLY
POWER SOURCE
20
T
M
10

FIG. 4

40
35
30
25
20
15
10
5
0
TEMPERATURE (K)
Tc TEMPERATURE (K) = -0.2 × AVERAGE PARTICLE DIAMETER (μm) + 35.35
R² = 0.9536
0
5
10
15
20
25
30
35
40
45
AVERAGE PARTICLE DIAMETER(μm)

**INTERNATIONAL SEARCH REPORT**

International application No. **PCT/JP2024/033854**

**A. CLASSIFICATION OF SUBJECT MATTER**

***H01B 12/00***(2006.01)i; ***C01B 35/04***(2006.01)i; ***G01F 23/22***(2006.01)i
FI: H01B12/00 ZAA; C01B35/04 C; G01F23/22 B

According to International Patent Classification (IPC) or to both national classification and IPC

**B. FIELDS SEARCHED**

Minimum documentation searched (classification system followed by classification symbols)

H01B12/00; C01B35/04; G01F23/22

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br><br>A | WO 2016/084513 A1 (HITACHI, LTD.) 02 June 2016 (2016-06-02)<br>paragraphs [0023], [0024] | 1<br><br>2-4 |
| X<br><br>A | JP 2007-139441 A (NATIONAL UNIVERSITY CORPORATION KOBE UNIVERSITY) 07 June 2007 (2007-06-07)<br>paragraphs [0048]-[0051], fig. 1 | 1, 3, 4<br><br>2 |
| A | WO 2014/162379 A1 (HITACHI, LTD.) 09 October 2014 (2014-10-09)<br>entire text, all drawings | 1-4 |
| A | JP 2007-304074 A (NATIONAL INSTITUTE FOR MATERIALS SCIENCE) 22 November 2007 (2007-11-22)<br>entire text, all drawings | 1-4 |

☑ Further documents are listed in the continuation of Box C. ☑ See patent family annex.

* Special categories of cited documents:

"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **25 November 2024** | **10 December 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

## INTERNATIONAL SEARCH REPORT

International application No.
**PCT/JP2024/033854**

### C. DOCUMENTS CONSIDERED TO BE RELEVANT

| Category* | Citation of document, with indication, where appropriate, of the relevant passages | Relevant to claim No. |
|---|---|---|
| A | WO 2014/076981 A1 (TOKYO WIRE WORKS, LTD.) 22 May 2014 (2014-05-22) entire text, all drawings | 1-4 |

Form PCT/ISA/210 (second sheet) (July 2022)

**INTERNATIONAL SEARCH REPORT**
**Information on patent family members**

International application No.
**PCT/JP2024/033854**

| Patent document cited in search report | Publication date (day/month/year) | Patent family member(s) | Publication date (day/month/year) |
|---|---|---|---|
| WO 2016/084513 A1 | 02 June 2016 | US 2017/0301444 A1<br>paragraph [0051], table 1 | |
| JP 2007-139441 A | 07 June 2007 | (Family: none) | |
| WO 2014/162379 A1 | 09 October 2014 | (Family: none) | |
| JP 2007-304074 A | 22 November 2007 | US 2007/0266795 A1<br>entire text, all drawings | |
| WO 2014/076981 A1 | 22 May 2014 | US 2015/0332811 A1<br>entire text, all drawings | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002211916 A
- JP 2000175034 A
- WO 2014162379 A